(19) Europäisches Patentamt
European Patent Office
Office européen des brevets

(11) **EP 2 060 659 B1**

(12) **EUROPÄISCHE PATENTSCHRIFT**

(45) Veröffentlichungstag und Bekanntmachung des Hinweises auf die Patenterteilung:
**31.10.2012  Patentblatt 2012/44**

(51) Int Cl.:
*C23C 18/16* (2006.01)      *C25D 7/06* (2006.01)
*C25D 17/00* (2006.01)      *H01L 31/18* (2006.01)

(21) Anmeldenummer: **08019694.2**

(22) Anmeldetag: **11.11.2008**

(54) **Vorrichtung und Verfahren zum Transport von flachem Gut in Durchlaufanlagen**

Device and method of transporting flat goods in continuous lines

Dispositif et procédé destinés au transport de produits plats dans des dispositifs de passage

(84) Benannte Vertragsstaaten:
**AT CH FR GB LI**

(30) Priorität: **13.11.2007   DE 102007054093**

(43) Veröffentlichungstag der Anmeldung:
**20.05.2009   Patentblatt 2009/21**

(73) Patentinhaber: **RENA GmbH**
**78148 Gütenbach (DE)**

(72) Erfinder: **Hübel, Egon**
**90537 Feucht (DE)**

(74) Vertreter: **Stürken, Joachim**
**Joachim Stürken**
**Patentanwaltsgesellschaft mbH**
**Kirchenhölzle 18**
**79104 Freiburg (DE)**

(56) Entgegenhaltungen:
**EP-A1- 0 561 184**       **DE-A1- 3 905 100**
**DE-A1-102005 038 449**   **DE-A1-102005 062 528**
**US-A- 5 176 158**        **US-A- 5 232 501**

Printed by Jouve, 75001 PARIS (FR)

## Beschreibung

Die Erfindung betrifft den Transport bzw. die Förderung von flachem Gut in nasschemischen und elektrolytischen Durchlaufanlagen. Bei dem Gut handelt es sich z.B. um Wafer, Solarzellen aus Silizium, Leiterplatten oder Hybride, die mindestens bei einem Prozess nur einseitig zu behandeln sind. Dabei soll die nicht zu behandelnde Seite des Gutes von der Behandlungsflüssigkeit nicht benetzt oder verunreinigt werden. Selbst geringste Benetzungen als Spuren müssen vermieden werden, um einen Ausschuss des Gutes zu vermeiden.

Stand der Technik und Nachteile

Die Druckschriften DE 10 2005 038 449 A1 und EP 0 992 617 A2 zeigen typische Durchlaufanlagen mit bekannten angetriebenen Fördermitteln als Walzen mit Ringen und Wellen sowie Rollen und Rädchen. Der Antrieb dieser Fördermittel erfolgt in der Regel mittels einer Transmissionswelle, die entlang der Durchlaufanlage parallel zur Transportbahn angeordnet ist. Einen derartigen weit verbreiteten Antrieb zeigt die Druckschrift DE 22 56 018 C3 in den Figuren 2, 3 und 4. Alle Wellen, Walzen und weitere Fördermittel sind untereinander durch die Transmissionswelle 44 und die Zahnräder schlupffrei miteinander verbunden, d.h. synchronisiert.

Durch die Anordnungen der Fördermittel in den genannten Durchlaufanlagen werden sowohl die Oberseite als auch die Unterseite des Gutes bestimmungsgemäß mit der Behandlungsflüssigkeit benetzt. Soll oder darf nur die Unterseite des Gutes benetzt werden, so bedarf es eines erheblich größeren Aufwandes, zumindest bei einer elektrolytischen Behandlung des Gutes. In diesem Falle reicht die Behandlungsflüssigkeit nur bis zur Unterseite des meist dünnen Gutes heran. Zur sicheren elektrischen Kontaktierung muss von beiden Seiten eine Kraft auf das flache Gut ausgeübt werden. Eine derartige Galvanisiereinrichtung beschreibt die Druckschrift DE 10 2005 039 100 A1. Die Oberseite des Gutes, z.B. Substrat als Solarzellen wird in einem Rahmen mittels Dichtungen gegen ein Eindringen der bis an die Unterseite desselben heranreichenden Behandlungsflüssigkeit geschützt. Sehr weiche Andruckrollen drücken die Solarzellen zur elektrischen Kontaktierung gegen die Kontakte der Rahmenvorsprünge. Der Rahmen dient zur Aufnahme mehrerer Solarzellen.

Bei den zuerst genannten beiden Druckschriften rollen die Transportmittel bzw. Kontaktmittel auf der Oberseite und Unterseite des Gutes ab. Transportmittel dienen nur zum Zwecke des Transports des Gutes. Die Kontaktmittel dienen zum Transport und zur elektrischen Kontaktierung des Gutes. Nachfolgend werden die Transportmittel und Kontaktmittel zusammengefasst als Fördermittel bezeichnet.

Selbst wenn das Niveau der Behandlungsflüssigkeit und die Höhe der Transportbahn so eingestellt sind, dass nur die Unterseite des Gutes benetzt wird, bleibt die Oberseite beim Stand der Technik mindestens partiell nicht trocken, weil das Gut in Abschnitten, z.B. als Solarzellen parallel und hintereinander durch die Durchlaufanlage gefördert wird. Zwischen jedem Gut befindet sich allseitig ein Freiraum von etwa 10 bis 25 mm, der nachfolgend in Förderrichtung als Längslücke mit der Länge $L_{11ü}$ und quer zur Förderrichtung als Querlücke mit der Länge $L_{qlü}$ bezeichnet wird. Die unteren rotierenden Fördermittel sind vollständig in der Behandlungsflüssigkeit eingetaucht und von ihr benetzt. Diesen Fördermitteln gegenüber befinden sich an der Oberseite des Gutes weitere Fördermittel. Sie rollen auf der Oberseite des dort zunächst trockenen Gutes ab. Nach jedem Abschnitt von Gut kommt eine Querlücke. In dieser Lücke rollt das obere noch trockene Fördermittel auf dem unteren nassen Fördermittel kurzzeitig ab, insbesondere dann, wenn das Gut sehr dünn ist und/oder wenn diese Querlücke die genannte Länge aufweist. Das obere Fördermittel nimmt dabei Behandlungsflüssigkeit vom unteren Fördermittel auf. Diese Behandlungsflüssigkeit wird dann auf die Oberfläche der Oberseite des nachfolgenden Gutes übertragen.

Eine Durchlaufanlage besteht in Förderrichtung z.B. aus 100 oder mehr rotierenden Transportwellen, die nachfolgend kurz als Wellen bezeichnet werden. Diese erstrecken sich quer über die gesamte Transportbahn. Auf den Wellen sind entsprechend der Anzahl der Förderbahnen quer zur Förderrichtung viele Fördermittel angeordnet. Wegen der großen Anzahl von Wellen wiederholt sich der Effekt der Übertragung der Behandlungsflüssigkeit vom unteren Fördermittel an die Oberseite des Gutes 100-mal oder öfters. Das Gut wird dadurch an der Oberseite mindestens im Bereich der Transportspuren durch die oberen Fördermittel benetzt, auch wenn das Niveau der Behandlungsflüssigkeit nicht bis zur Oberseite heranreicht.

Die Druckschrift DE 103 13 127 B4 beschreibt ein nasschemisches Ätzverfahren für Substrate, bei dem die Flüssigkeitshöhe so eingestellt wird, dass nur die Unterseite der Substrate einschließlich der Kanten benetzt wird. Ebenso beschreibt die DE 10 2005 062 528 A1 ein Verfahren sowie eine Vorrichtung zur Oberflächenbehandlung von Substraten, bei der die Substrate auf Transportmitteln aufliegen, die derart in der Flüssigkeit angeordnet sind, dass die gewünschte einseitige Benetzung der Substratunterseite lediglich indirekt durch den Kontakt mit den Transportmitteln erfolgt. Weil das flache Gut allein auf unteren Fördermitteln aufliegt, wird in diesen Fällen die Oberseite nicht benetzt. Diese Verfahren eignen sich jedoch nicht zur elektrolytischen Behandlung von Gut. Hierzu bedarf es einer elektrischen Kontaktierung, die bei Gut, das nur auf unteren Fördermitteln aufliegt, nicht realisierbar ist. Das Gut muss von oberen und unteren Fördermitteln als Kontaktmittel transportiert und mit einer bestimmten Mindestkontaktkraft beaufschlagt und elektrisch kontaktiert werden.

Aufgabe der Erfindung ist es, die horizontale Förderung von nur an einer Seite, nämlich der Unterseite, nasschemisch und/oder elektrolytisch zu behandelndem Gut in Durchlaufanlagen zu ermöglichen, wobei sich an der Oberseite und Unterseite des Gutes entlang der Transportbahn rotierende Transportmittel oder Kontaktmittel in Kontakt mit dem Gut befinden. Die nur bis an die Unterseite des flachen Gutes heranreichende, gewöhnlich innerhalb eines Arbeitsbehälters befindliche Behandlungsflüssigkeit soll dabei nicht auf die trockene Oberseite übertragen werden.

Gelöst wird die Aufgabe durch die Vorrichtung nach Patentanspruch 1 und durch das Verfahren nach Patentanspruch 12. Die Unteransprüche beschreiben vorteilhafte Ausführungen der Erfindung.

Beschreibung

Die Verfahren zur Behandlung von z.B. Wafern, Solarzellen oder Hybriden betreffen u. a. das Reinigen, Dotieren, Aktivieren, Passivieren, Texturieren, chemisches Ätzen sowie das Galvanisieren und das elektrolytische Ätzen, jeweils mit den erforderlichen Spül- und Trocknungsprozessen. Derartiges Gut wird in sehr großer Stückzahl produziert. Daher werden die Durchlaufanlagen zur Produktion eines mindestens in den Abmessungen stets gleichbleibenden Gutes hergestellt.

Die Erfindung wird nachfolgend am Beispiel von Solarzellen mit den weit verbreiteten Abmessungen 156 x 156 mm$^2$ beschrieben. Sie gilt jedoch uneingeschränkt auch für anderes flaches Gut, das als Abschnitte mit gleicher Länge mindestens in Förderrichtung in Durchlaufanlagen einseitig nasschemisch und/oder elektrolytisch zu behandeln ist.

Die Behandlung der Solarzellen stellt eine ganz besondere technische Herausforderung dar. Die Dicke dieser Siliziumscheiben beträgt z.B. 140 $\mu$m oder weniger. Daher sind sie sehr Bruch empfindlich. Die bei der Nassbehandlung trocken zu haltende Oberfläche der Oberseite reagiert mit den Behandlungsflüssigkeiten meist sehr heftig, d.h. sie muss gegen eine Benetzung sicher geschützt werden. Dies bedeutet, dass auch die oberen Fördermittel in den oben beschriebenen Querlücken nicht von den unteren Fördermitteln benetzt werden dürfen. Gleiches gilt für andere Produkte als Abschnitte, die mit trockener Oberseite zu behandeln sind.

Die Erfindung sieht vor, dass sich die oberen Fördermittel einer Welle beim Abrollen auf der Oberseite rechtzeitig vor dem Eintreffen einer Querlücke vom Gut und damit sowohl vom Niveau der innerhalb eines Arbeitsbehälters befindlichen Behandlungsflüssigkeit als auch von den nassen unteren Fördermitteln, die den oberen Fördermitteln gegenüber angeordnet sind, distanzieren, d.h. räumlich entfernen und dass diese Fördermittel erst nach dem Passieren der Querlücke wieder auf der trockenen Oberseite des nachfolgenden Gutes aufsetzen. Für die sehr vielen Fördermittel einer Durchlaufanlage sieht die Erfindung zwei überraschend kostengünstige konstruktive Lösungen vor. Sie leiten die erforderlichen Bewegungen der Konstruktionselemente bevorzugt von dem bereits vorhandenen Antrieb für die Fördermittel der Durchlaufanlage ab.

Die Umfangsgeschwindigkeit der oberen und unteren Fördermittel entspricht der Fördergeschwindigkeit v bzw. der Vorschubgeschwindigkeit des Gutes. Wird z.B. der Umfang u mindestens der oberen rotierenden Fördermittel so groß gewählt, wie die Summe der Länge $L_g$ des Gutes in Förderrichtung plus der Länge $L_{qlü}$ der Querlücke in der selben Richtung, dann trifft bei jeder Umdrehung des Fördermittels ein bestimmter Punkt an seinem Umfang u immer die identische Stelle der nacheinander die Durchlaufanlage durchfahrenden Solarzellen bzw. der jeweiligen Querlücken, die bei der Beschickung der Durchlaufanlage stets gleich groß gebildet werden. Dieser Punkt soll nachfolgend mit Phasenwinkel $\varphi$ = 0° des 360° Umfanges u eines Fördermittels bezeichnet werden. Die Summe der Längen $L_g$ plus $L_{qlü}$ wird nachfolgend als Bruttogutlänge $L_{gbr}$ des Gutes bezeichnet. Für die Solarzellen mit den Abmessungen 156 x 156 mm$^2$ soll als Beispiel.zunächst eine Länge $L_{qlü}$ der Querlücke von 24 mm angenommen werden. Dies ergibt eine Bruttogutlänge $L_{qbr}$ von 180 mm.

In einer Durchlaufanlage werden in der Regel mehrere gleiche Güter, z.B. Solarzellen parallel, d.h. nebeneinander beschickt und eingefahren. Die Wellen, die quer zur Förderrichtung angeordnet sind, enthalten entsprechend viele Förderspuren, z.B. 10 mit den quer zur Förderrichtung erforderlichen Transportmitteln und/oder Kontaktmitteln auf jeder Welle. Die Förderspuren werden nachfolgend mit Großbuchstaben bezeichnet, z.B. A bis J für 10 Förderspuren. Jede Welle befindet sich in Förderrichtung auf einer Position der Durchlaufanlage, die hier mit Ziffern bezeichnet werden sollen, z.B. Pos. 1 für die erste Welle der Durchlaufanlage.

Zur sicheren Förderung wird das Gut in Förderrichtung vorteilhaft von den Fördermitteln, die sich auf mindestens zwei oberen und unteren Wellen befinden, erfasst und gefördert. Die Fördermittel können als Transporträder, Transportringe, Transportscheiben oder Kontaktmittel als Kontakträger oder segmentierte Kontakträger ausgebildet sein. Bevorzugt sind die Fördermittel als Kontaktmittel ausgebildet, die sich nur an der Oberseite des Gutes zur elektrolytischen Behandlung der Unterseite des Gutes befinden. Der Abstand a der Wellen oder Walzen in Förderrichtung ist allgemeinen unabhängig von den Abmessungen des Gutes und der Querlücke. Er richtet sich jedoch nach der Bruttogutlänge $L_{gbr}$, denn zur sicheren Förderung sollten stets mindestens zwei Fördermittel in Förderrichtung, und mindestens zwei Fördermittel quer zur Förderrichtung im Eingriff sein. Damit beträgt der maximale Abstand a der Wellen für die Solarzelle mit den oben angegebenen Abmessungen z.B. 75 mm.

Wenn Güter in einer Förderspur mit gleich großer Länge in Förderrichtung und mit stets gleich großer Querlücke in die Durchlaufanlage einfahren, dann besteht bei allen Wellen, auf denen sich die Fördermittel mit dem Umfang u befinden, der der Bruttogutlänge $L_{gbr}$ entspricht, ein stets gleichbleibender individueller Bezug zwischen einem bestimmten Phasenwinkel $\varphi$ jedes Fördermittels einer Welle und der Transportposition des Gutes im Bereich dieses Fördermittels.

Das Fördermittel rotiert fortlaufend um 360°. Zur Beschreibung der Erfindung soll der Phasenwinkel $\varphi = 0°$ der Fördermittel per Definition stets die Mitte der Querlücke zwischen zwei aufeinander folgenden Gütern treffen. Als Bezugspunkt für den Phasenwinkel $\varphi = 0°$ könnte auch jede andere Stelle im Bereich der Bruttogutlänge $L_{gbr}$ gewählt werden, z.B. die vorlaufende Kante des Gutes.

Alle Wellen der Durchlaufanlage sind z.B. mittels der bekannten Transmissionswelle parallel zur Transportbahn und der zugeordneten Zahnräder untereinander synchronisiert. Diese gemeinsame Transmissionswelle treibt schlupffrei über Kegelzahnräder und Stirnzahnräder die unteren und oberen Wellen und damit die auf den Wellen befindlichen Fördermittel jeder Position an. Somit besteht für alle Fördermittel der Durchlaufanlage ein gleichbleibender Bezug ihrer Phasenwinkel $\varphi$ zueinander, d.h. sie sind untereinander synchronisiert.

Der Antrieb und die Synchronisation der Fördermittel untereinander beschränkt sich nicht auf die Transmissionswelle mit den Zahnrädern. Alle bekannten Antriebselemente und zugehörigen Synchronisationsmittel sind erfindungsgemäß anwendbar. Hierzu gehören u. a. Ketten und Kettenräder, Zahnriemen und Zahnräder sowie elektrisch synchronisierte Einzel- oder Gruppenantriebe und elektrische Wellen sowie Kombinationen dieser Antriebselemente und Mittel.

Die Phasenwinkel $\varphi = 0°$ aller Fördermittel jeder individuellen Welle, d.h. jeder Position in der Durchlaufanlage werden bei der Inbetriebnahme der Anlage so positioniert bzw. eingestellt, dass sie sich über der Mitte der Querlücke von zunächst gedanklich oder tatsächlich eingefahrenem Gut befinden. Nach einem Vorschub von einem Gut und der zugehörigen Querlücke steht dann der Phasenwinkel $\varphi = 0°$ jedes Fördermittels erneut über der Mitte einer Querlücke und zwar der in Förderrichtung nachfolgenden. Voraussetzung hierfür ist, dass der Umfang u der Fördermittel wie oben beschrieben, dimensioniert wurde. Diese Nullstellung der Fördermittel, d.h. die Grundeinstellung gilt individuell für jede Förderspur und für jede Position der Wellen in der Durchlaufanlage.

Wird das parallele Gut quer zur Förderrichtung zum selben Zeitpunkt in die Durchlaufanlage eingefahren, dann sind die Phasenwinkel $\varphi$ der Fördermittel einer Welle gleich ausgerichtet, d.h. sie befinden sich auf einer Mantellinie. Wird das Gut quer zur Förderrichtung in kurzen zeitlichen Abständen sequentiell, z.B. von einem Roboter beschickt, dann befinden sich die Phasenwinkel $\varphi$ der Fördermittel einer Welle auf versetzten Mantellinien.

Wegen des hier im Beispiel zunächst gewählten Abstandes a der Wellen in Förderrichtung von a = 75 mm besteht keine besondere Beziehung des Abstandes a zur Bruttogutlänge $L_{gbr}$. Dies bedeutet, dass der Phasenwinkel $\varphi = 0°$ jedes Fördermittels auf den Wellen in jeder Position der Durchlaufanlage individuell einzustellen ist. Dieser Aufwand kann vermieden werden. Hierzu ist der Abstand a der Wellen von Position zu Position so groß zu wählen, dass er einen Stammbruchteil der Bruttogutlänge $L_{gbr}$ beträgt. Bei dieser Dimensionierung wiederholen sich die Einstellungen des Phasenwinkel $\varphi = 0°$ der Fördermittel auf den Wellen entlang der Transportbahn bereits nach jeder Bruttogutlänge $L_{gbr}$ in Förderrichtung. Jede Wiederholung bildet eine Gruppe von Wellen der Durchlaufanlage mit den darauf gleich ausgerichteten Fördermitteln. In jeder Gruppe treten die jeweiligen Situationen der rotierenden Wellen in der gesamten Durchlaufanlage zur gleichen Zeit auf. Dies erleichtert die Inbetriebnahme einer Durchlaufanlage wesentlich, denn es gibt in der gesamten Durchlaufanlage für die als Beispiel genannten Solarzellen nur zwei, drei oder vier unterschiedliche Wellen, bzw. Anordnungen der Fördermittel auf den Wellen.

Für die Solarzellen mit einer Länge von $L_g = 156$ mm und mit einer gewählten Bruttogutlänge $L_{gbr} = 172,78$ mm ergeben sich dann folgende Dimensionierungen bzw. Abmessungen:

- Breite der Querlücke $L_{qlü} = 16,78$ mm für einen ganzzahligen Durchmesser D der Fördermittel.

- Durchmesser D der Fördermittel $D = 172,78 / \pi = 55$ mm.

- Der Abstand a der Wellen in Förderrichtung kann bei einem Außendurchmesser der Fördermittel von D = 55 mm drei zu bevorzugende Stammbruchteile betragen:

$$a = \tfrac{1}{4} \ * \ 172,78 \ mm = 43,2 \ mm$$

oder

$$a = 1/3 * 172,78 \text{ mm} = 57,6 \text{ mm}$$

oder

$$a = \frac{1}{2} * 172,78 \text{ mm} = 86,4 \text{ mm}.$$

.

Ist der Abstand a kleiner als der Außendurchmesser der Fördermittel, dann müssen diese verschachtelt angeordnet werden. Dies ergibt dann eine doppelte Anzahl von Fördermittelspuren auf dem Gut. Der Abstand a = 57,6 mm erlaubt den Einsatz von spurgleichen Fördermitteln auf den Wellen. Bei a = 86,4 mm befindet sich zeitweise je Förderspur nur eine Welle mit z.B. zwei Fördermitteln quer zur Förderrichtung im Eingriff, was bei einer chemischen und/oder elektrolytischen Behandlung des Gutes ausreichend ist.

Bei einem Abstand a = 86,4 mm wiederholen sich die Einstellungen der Phasenwinkel $\varphi = 0°$ nach jeder zweiten Welle bzw. Position in der Durchlaufanlage. Eine Gruppe von Wellen besteht dann aus nur zwei unterschiedlich justierten Wellen. Bei a = 57,6 mm erfolgt die Wiederholung nach jeder dritten Welle und bei a = 43,2 mm erfolgt die Wiederholung nach jeder vierten Welle. Dies erleichtert nicht nur die einmalig vorzunehmenden Einstellungen bei der Inbetriebnahme der Durchlaufanlage, sondern es eröffnen sich auch weitere Möglichkeiten zur Gruppensteuerung der Fördermittel, wie es unten beschrieben wird.

Wegen der im Allgemeinen großen Länge einer Durchlaufanlage empfiehlt es sich, die errechneten Abstände a für die Arbeitstemperatur des meist aus Kunststoff bestehenden Arbeitsbehälters zu realisieren. Damit werden die ansonsten kleinen Temperaturfehler bei der Synchronisation des Gutes und der Fördermittel vermieden.

Es besteht natürlich auch die Möglichkeit, die Konstruktionselemente so zu dimensionieren, dass sich ganzzahlige Abstände der Wellen errechnen. Dies ergibt dann eine Bruchzahl für den Durchmesser der Fördermittel und/oder der Länge der Querlücke. In allen Fällen steht die Startzeit zum Einfahren des Gutes in einem festen Bezug zu den synchronisierten Antriebselementen und Fördermitteln. Der Start erfolgt für jede Förderspur zeitlich so, dass der Phasenwinkel $\varphi = 0°$ der ersten Welle der Durchlaufanlage, d.h. in Position 1 die Mitte der Querlücke trifft. Dies setzt sich dann von Welle zu Welle in der Durchlaufanlage fort, wenn die Antriebselemente und Fördermittel nach obigen Regeln dimensioniert, justiert und synchronisiert wurden.

Mittels eines absoluten oder inkrementalen Winkelcodierer, z.B. an der Transmissionswelle angeordnet, kann die Winkelstellung der Fördermittel in das Steuerungssystem der Durchlaufanlage zu weiteren Steuerungsfunktionen gemeldet werden. Bei elektrolytischen Prozessen kann mit den erfindungsgemäßen Mitteln auch das Unterbrechen der Stromzuführung mit mechanischen Mitteln zu bestimmten Zeiten mit und während der Förderung des Gutes synchronisiert werden. Die Gleichrichter können z.B. gruppenweise oder einzeln auch mit elektrischen oder elektronischen Mitteln mit dem Transport synchronisiert ein- und ausgeschaltet werden. Sie werden z.B. beim Annähern einer Querlücke an ein Kontaktrad ausgeschaltet und nach dem Passieren der Querlücke wieder eingeschaltet.

Die konstanten Beziehungen der Antriebselemente zum geförderten Gut in der gesamten Durchlaufanlage nutzend, wird erfindungsgemäß mindestens an den oberen Fördermitteln im Bereich des Phasenwinkels $\varphi = 0°$ die Berührung des Gutes und der Fördermittel unterbrochen. Dies geschieht durch Entfernen der Berührungsflächen von Gut und Fördermittel. Damit können die oberen Fördermittel auch im Bereich der Querlücken von der Behandlungsflüssigkeit nicht benetzt werden. Die Zeitdauer der Distanzierung wird u. a. von der Fördergeschwindigkeit des Gutes bestimmt. Erfindungsgemäß geschieht die Distanzierung durch unterschiedliche Mittel.

Zusammenfassend kann durch die Formgebung der Fördermittel eine Steuerung der periodischen Distanzierung der mindestens an der Oberseite des Gutes rotierenden Fördermittel von der Oberfläche des Gutes erreicht werden.

Das erste Mittel zur Distanzierung sieht Steuerungskomponenten vor. Durch formschlüssige und/oder kraftschlüssige Steuerung werden die oberen rotierenden Fördermittel einer Welle oder Wellengruppe angehoben, wenn sich ihnen eine Querlücke zwischen zwei Gütern nähert. Nach dem Passieren der Querlücke werden die betreffenden Fördermittel einer Welle oder Wellengruppe durch die Steuerung wieder abgesenkt und auf den Oberflächen der jeweiligen Güter quer zur Förderrichtung aufgesetzt. Zur Steuerung bzw. Synchronisation aller Antriebselemente und aller Fördermittel der gesamten Durchlaufanlage eignen sich die bekannten Steuerungsmittel und Methoden. Hierzu gehören elektrische und elektronische, pneumatische, hydraulische und elektromechanische sowie mechanische Steuerungen und Antriebe. So kann die Distanzierung der Fördermittel jeweils einer Welle oder Wellengruppe z.B. durch elektromagnetische, permanentmagnetische oder motorische Kräfte, durch Getriebe, Kurbelgetriebe, Kurvensteuerung, Kurbelmechanik oder Nockensteuerungen erfolgen.

Das zweite Mittel zur Distanzierung sieht mit dem Antrieb der Durchlaufanlage synchronisierte Fördermittel auf den Wellen oder Wellengruppen vor, die an ihrem Umfang mit mindestens einer Aussparung versehen sind. Im Bereich der Aussparung ist der Radius kleiner als im übrigen Bereich der Fördermittel. Die Bogenlänge b der Aussparung ist mindestens so lang wie die Länge der Querlücke. Bei Rotation entfernen sich die berührenden Flächen von Gut und Fördermittel im Bereich der Aussparung wegen des kleineren Radius selbsttätig von der Oberfläche des Gutes. Der Phasenwinkels $\varphi$ = 0° der Fördermittel befindet sich in der Mitte des Bogens der Aussparung. Dieser Phasenwinkels $\varphi$ = 0° ist auf den synchronisierten Wellen so eingestellt, dass er wieder die Mitte der Querlücke trifft. Dabei bleibt der Abstand der Wellenmittellinien, auf denen sich die Fördermittel befinden, zur Oberfläche des Gutes, d.h. in ihrer Höhenlage nahezu konstant. Nach dem Passieren der Querlücke nähert sich der Umfang des betreffenden Fördermittels am Ende der Aussparung der Oberfläche des Gutes und setzt auf dieser wieder auf.

Auch Kombinationen des ersten und des zweiten Mittels sind realisierbar.

Ausführungsbeispiele für das erste Mittel:

- Formschlüssige Steuerung am Beispiel einer Nockensteuerung:

  Beidseitig einer oberen Welle befindet sich bevorzugt außerhalb der Transportbahn je ein Nockenrad mit mindestens einer Nocke, die die Bogenlänge b hat. Die Mitte der Nocke bzw. der Bogenlänge b markiert den Phasenwinkel $\varphi$ = 0°. Zwei zugehörige Nockenbahnen, die z.B. beidseitig am Arbeitsbehälter fixiert sind, befinden sich unterhalb der Nockenräder. Die beiden Nocken einer Welle laufen kurz vor Erreichen des Phasenwinkels $\varphi$ = 0° auf die Nockenbahnen auf, und heben die Welle senkrecht nach oben. Kurz nach dem Phasenwinkel $\varphi$ = 0° verlassen die Nocken die Nockenbahnen, wodurch sich die Welle absenkt und die Fördermittel wieder in Kontakt mit den Oberflächen der Güter im Bereich der Welle bringt. Bei Bedarf, d.h. bei langen Wellen können auch in der axialen Mitte der Wellen Nockenräder und Nockenbahnen angeordnet sein.

  An Stelle einer feststehenden Nockenbahn kann auch ein rotierendes Distanzrad mindestens beidseitig auf der unteren Welle angeordnet sein. Auf dieses Distanzrad läuft die Nocke des auf der oberen rotierenden Welle befestigten Nockenrades auf. Dabei hebt sie wieder die obere Welle für die Zeit der Bogenlänge b nach oben, wodurch das Gut und im Bereich der Querlücke das untere Fördermittel vom oberen Fördermittel nicht berührt werden. Die Distanzräder können umgekehrt auch auf der oberen rotierenden Welle angeordnet sein. Entsprechend befinden sich dann auf der unteren Welle die zugehörigen Nockenräder.

  Bei dem Phasenwinkel $\varphi$ = 0° befindet sich per Definition die Querlücke unterhalb der betreffenden Welle. Hierfür wurden bei der Inbetriebnahme der Durchlaufanlage die Phasenwinkel $\varphi$ der Fördermittel auf den Wellen eingestellt. Der Start des Gutes in die Durchlaufanlage erfolgt zum dafür vorgegebenen Zeitpunkt. Die Bogenlänge b der Nocke über dem Umfang des Nockenrades, das wie auch alle Fördermittel fest mit der Welle verbunden ist, bestimmt die Dauer der Distanzierung von Fördermittel und Gut bei jeder Umdrehung. Bei diesem Ausführungsbeispiel ist es erforderlich, dass das parallele Gut quer zur Förderrichtung zum gleichen Zeitpunkt in die Durchlaufanlage einfährt, weil alle Fördermittel einer Welle gemeinsam gesteuert sind.

- Formschlüssige Steuerung am Beispiel einer Kurvensteuerung:

  Die oberen und unteren Wellen sind mittels Zahnräder, Ketten oder Zahnriemen miteinander verbunden. Zugleich sind Kurvenräder und Distanzräder als Gegenräder auf diesen Wellen angeordnet. Die Kurvenräder haben eine exzentrische Befestigung auf der Welle. Die größte Distanz der oberen Welle von der unteren Welle wird so eingestellt, dass sie bei dem Phasenwinkel $\varphi$ = 0° erreicht wird und dass außerhalb der Bogenlänge b die Fördermittel auf der Oberfläche des Gutes abrollen.

  Ähnlich dieser Kurvensteuerung können die zur Förderung des Gutes bereits vorhandene Stirnzahnräder auf den Wellen die Funktion der Distanzierung von Gut und Fördermittel mit übernehmen. Dies geschieht z.B. durch Anordnung der Zähne eines oder beider paarweise im Eingriff befindlicher Stirnzahnräder im Bereich der Bogenlänge (n) b auf einem größeren Teilkreis. In diesem Bereich können auch der Zahngrund geringfügig ausgefüllt und/oder der Zahnkopf erhöht werden. Hierdurch wird ohne wesentlichen technischen Mehraufwand wieder die Distanzierung erreicht.

- Kraftschlüssige Steuerung am Beispiel von Hubzylindern:

  Elektromechanische, pneumatische oder hydraulische Hubzylinder zu beiden Seiten der Wellen werden vom Steuerungssystem der Durchlaufanlage so gesteuert, dass diese die oberen Wellen einzeln oder in Gruppen, in Förderrichtung gesehen, im Bereich der Bogenlänge b heben und vom Gut distanzieren. Die Gruppensteuerung ist dann möglich, wenn der Abstand a der Wellen in Förderrichtung einen Stammbruchteil der Bruttogutlänge $L_{gbr}$ beträgt, wie es oben beschrieben wurde.

  Gesteuerte Elektromagnete können die Wellen im Bereich der Bogenlänge b anheben und vom Gut entfernen. Hierzu müssen entsprechende ferromagnetische Konstruktionselemente auf den oberen Wellen verwendet werden. Auch Permanentmagnete sind zur Distanzierung geeignet. Sie befinden sich auf der Welle rotierend oder am Arbeitsbehälter feststehend. Jeweils gegenüber sind die ferromagnetischen Konstruktionselemente als Anzugspartner angeordnet.

Des Weiteren besteht die Möglichkeit zur Distanzierung mittels Steuermotoren bzw. Servomotoren. Diese sind besonders dann vorteilhaft, wenn Gruppen von Wellen, die ein großes Gewicht haben, zu steuern sind.

Ausführungsbeispiele für das zweite Mittel:

- Formsteuerung durch Gestaltung der Fördermittel:

  Zur Distanzierung wird mindestens eine Aussparung am Umfang des oberen trockenen Fördermittels im Bereich des Phasenwinkels $\varphi = 0°$ vorgesehen. Die Bogenlänge b der Aussparung kann z.B. 45° betragen. Sie hat einen Zentriwinkel □. Die Mitte der Bogenlänge b bzw. des Zentriwinkels $\beta$ entspricht dem Phasenwinkel $\varphi = 0°$, der gemäß Definition auf die Mitte der Querlücke trifft. Durch die Aussparung mit dem dort befindlichen kleineren Radius entfernt sich selbsttätig das trockene rotierende Fördermittel zeitweise und periodisch von der Oberfläche des Gutes und damit auch von der Oberfläche der Behandlungsflüssigkeit. Das Niveau der Behandlungsflüssigkeit reicht im Arbeitsbehälter der Durchlaufanlage wieder nur bis an die Unterseite des Gutes heran.

Bei diesem zweiten Mittel der Erfindung ist der Phasenwinkel $\varphi = 0°$ für jedes Fördermittel einer Förderspur des Guts auf der Welle mit mehreren Förderspuren individuell einstellbar. Dies erlaubt zur Distanzierung auch das individuelle, d.h. das zeitlich versetzte Einfahren des Gutes in jeder Förderspur. Die Einstellungen wiederholen sich in Förderrichtung in jeder Gruppe von Wellen. Die beschriebene Bogenlänge b der Fördermittel ist mit einem Radius versehen, der kleiner ist als der übrige Umfangsbereich des Fördermittels. Im Bereich des Zentriwinkels $\beta$ kann erfindungsgemäß das obere trockene Fördermittel nicht von dem gegenüberliegenden unteren nassen berührt werden.

Weil in Förderrichtung die Anzahl der Wellen vorteilhaft so groß gewählt wird, dass aus Gründen einer zuverlässigen Förderung und/oder einer sicheren elektrischen Kontaktierung mindestens zwei Fördermittel je Gut, bzw. je Solarzelle im Kontakt mit diesem stehen, so ist das zeitweise Entfernen einer Welle und/oder der darauf befindlichen Fördermittel ohne Einfluss auf die Förderung des Gutes in der Durchlaufanlage. Bei Solarzellen sind zudem quer zur Förderrichtung je Solarzelle meist auch noch zwei Transport- oder Kontaktspuren vorhanden, wodurch zu jeder Zeit genügend viele Fördermittel je Solarzelle im Eingriff sind.

Für die oben genannten Solarzellen mit einer Gutlänge $L_g$ in Förderrichtung von 156 mm und einer Länge der Querlücke $L_{qlü}$ von gewählten 16,78 mm beträgt der äußere Umfang u und damit die Bruttogutlänge $L_{gbr}$ der Fördermittel

$$L_{gbr} = L_g + L_{qlü} = 156 \text{ mm} + 16,78 \text{ mm} = 172,78 \text{ mm}.$$

Die Bogenlänge b mit dem kleineren Radius muss mindestens so lang sein, wie die Querlücke $L_{qlü}$. Zu empfehlen ist ein zusätzlicher Sicherheitszuschlag z für Toleranzen und für einen Schlupf, der bei der Förderung der Solarzellen auftreten kann. Für das angeführte Beispiel empfiehlt sich z.B. eine Bogenlänge b

$$b = L_{qlü} + z = 16,78 \text{ mm} + 23,22 \text{ mm} = 40 \text{ mm}$$

Der gewählte Sicherheitszuschlag z teilt sich auf die rücklaufende Kante der voraus geförderten Solarzelle und auf die vorlaufende Kante der nachfolgenden Solarzelle etwa zu gleich großen Strecken auf.

Nachfolgend wird der Bogen b am Umfang der Fördermittel mit dem kleineren Radius als Abstandsbogen bezeichnet. Unter äußerem Umfang u wird hier der Umfang verstanden, der sich ohne Abstandsbogen ergibt, also der Vollkreis des Fördermittels. Damit der Abstandsbogen des Fördermittels bei jeder Umdrehung mit seiner Mitte auch die Mitte jeder Querlücke möglichst genau trifft, müssen die parallel und nacheinander durch die Durchlaufanlage geförderten Solarzellen zu einem bestimmten Zeitpunkt starten, der mit der Winkelstellung des Abstandsbogens der Fördermittel und mit der einmalig festgelegten Bruttogutlänge $L_{gbr}$ in fester Beziehung steht. Weil in diesem Beispiel bei jeder Umdrehung der Wellen bzw. Transportwellen, auf denen sich nebeneinander mehrere Fördermittel für die parallel zu fördernden Solarzellen befinden, genau eine Solarzelle vorwärts bewegt wird, ändert sich, von Toleranzen und Schlupf abgesehen, an der Winkelbeziehung entlang der Transportbahn nichts. Jeder Querlücke steht ein Abstandsbogen gegenüber. Die geringfügigen genannten Fehler werden von dem gewählten Sicherheitszuschlag z aufgefangen.

Auch die unteren Fördermittel können mit Abstandsbögen versehen sein. In diesem Falle kann in Abhängigkeit von der Viskosität der Behandlungsflüssigkeit im Bereich der Querlücken das momentane Niveau beeinflusst, d.h. periodisch geringfügig abgesenkt werden.

Bei sehr langen Transportbahnen können für alle erfindungsgemäßen Lösungen entlang der Transportbahn Korrekturstationen zur Transportkorrektur eingefügt werden. Bei Abweichungen des Vorschubes des Gutes durch Schlupf stellen diese die erforderliche Winkelbeziehung zum Antrieb durch ein Verschieben des Gutes korrigierend wieder her. Zugleich korrigieren diese Korrekturstationen mögliche Synchronisationsfehler in Folge von temperaturbedingten Veränderungen der Länge der Durchlaufanlage.

Die hier beispielhaft genannten Maße und Winkel gelten sinngemäß für beide Mittel zur Ausführung der Erfindung. Dementsprechend kann es ferner auch vorgesehen sein, das die Distanzierung von Gut und Fördermittel bei jeder Umdrehung des bzw. der Fördermittel genau einmal erfolgt. Alternativ hierzu kann die Distanzierung nach mehr oder weniger als einer vollen Umdrehung des bzw. der Fördermittel vorgenommen werden. In den obigen Beispielen hat der Umfang u der Fördermittel die Bruttogutlänge $L_{gbr}$. Der Umfang u kann auch die Länge eines Stammbruchteiles der Bruttogutlänge $L_{gbr}$ in Förderrichtung aufweisen. In diesem Falle steht ein Abstandsbogen bzw. eine Aussparung oder eine beschriebene Nocke erst nach zwei oder mehr vollen Umdrehungen wieder einer Querlücke gegenüber. Zwischenzeitlich entfernt sich das oder die Fördermittel einer Welle kurzzeitig von der Oberseite des Gutes, was problemlos ist, weil bei längerem Gut viele Wellen mit phasenversetzten Fördermitteln im Eingriff sind. Diese Dimensionierung der Fördermittel eignet sich besonders für längeres Gut in Förderrichtung mit vergleichsweise kurzen Querlücken, wie z.B. für Leiterplatten.

Bei besonders kurzen Gütern wie z.B. Hybride können sich mit gleich großer Teilung auch zwei oder mehrere Abstandsbögen oder Aussparungen am Umfang eines Fördermittels bzw. Nocken am Nockenrad befinden, wobei ihre Anzahl ganzzahlig mit gleich großer Teilung sein muss. Der Mittenabstand der Abstandsbögen oder Aussparungen bzw. Nocken am Umfang der Fördermittel entspricht in diesem Falle der Bruttogutlänge $L_{gbr}$. Damit werden bei jeder vollen Umdrehung des Fördermittels zwei oder mehrere Güter gefördert. Zur Erzielung der Transportsicherheit können bei dem kurzen Gut die Fördermittel verschachtelt angeordnet werden. Die Abstandsbögen oder Aussparungen können dabei sowohl an den Fördermitteln der oberen und/oder unteren Wellen angeordnet sein.

Beide erfindungsgemäßen Mittel zur Lösung der Aufgabe nutzen zur Distanzierung bevorzugt den in der Durchlaufanlage bereits vorhandenen Antrieb der Fördermittel, wodurch die Erfindung kostengünstig realisierbar ist.

Figurenbeschreibung

Die Erfindung wird nachfolgend an Hand der schematischen und nicht maßstäblichen Figuren 1 bis 5 weiter beschrieben.

**Figur 1a** zeigt für das erste Mittel der Erfindung ein Ausführungsbeispiel mit Wellen in der Seitenansicht zum Zeitpunkt t1.

**Figur 1b** zeigt dasselbe Beispiel zum Zeitpunkt t2.

**Figur 1c** zeigt ebenfalls dasselbe Beispiel zum Zeitpunkt t3.

**Figur 2** zeigt die Situationen der Figuren 1a bis 1c quer zur Förderrichtung bei der Position n + 2 zu den Zeitpunkten t1, t2 und t3.

**Figur 3** zeigt für das zweite Mittel der Erfindung ein Ausführungsbeispiel mit Wellen in der Seitenansicht zu den Zeitpunkten t1, t2 und t3.

**Figur 4** zeigt die Situationen der Figur 3 quer zur Förderrichtung bei der Position n + 2 zu den Zeitpunkten t1, t2 und t3.

**Figur 5** zeigt in der Draufsicht das zeitlich versetzte Einfahren von Gut als Solarzellen zur Behandlung in einer Durchlaufanlage mit Wellen gemäß der Figuren 3 und 4.

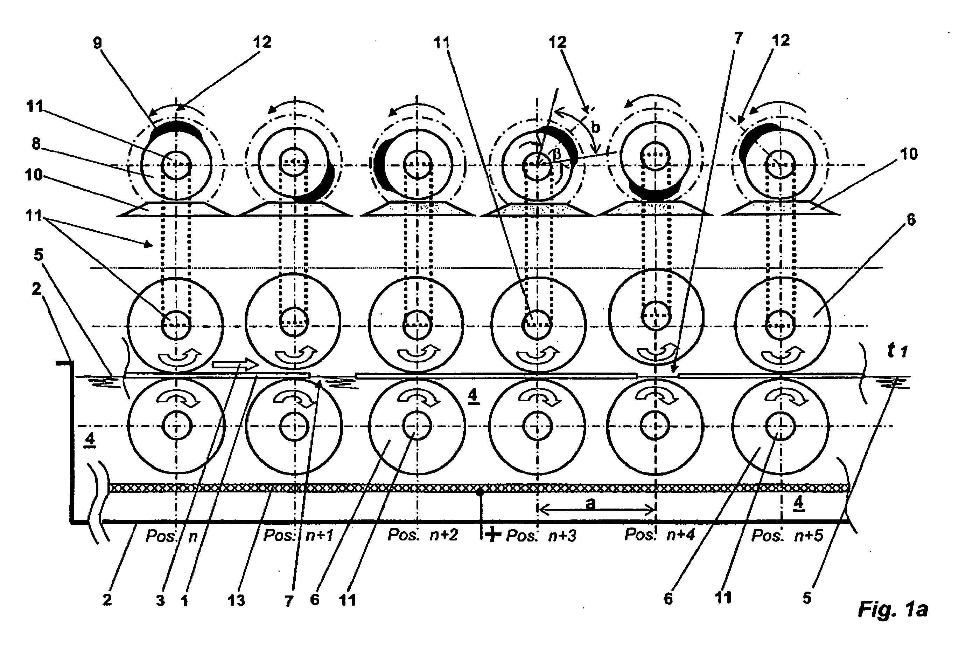

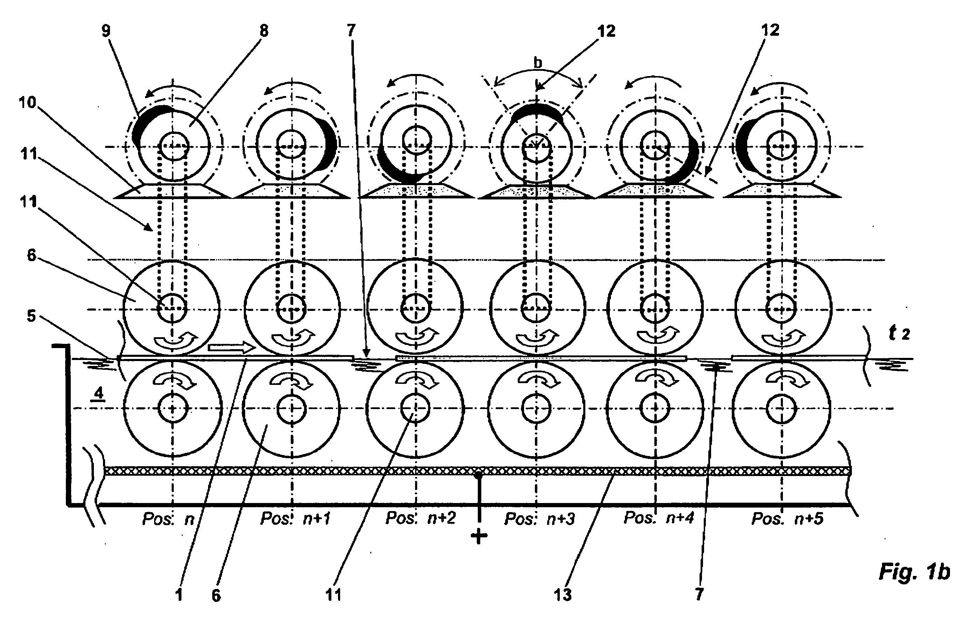

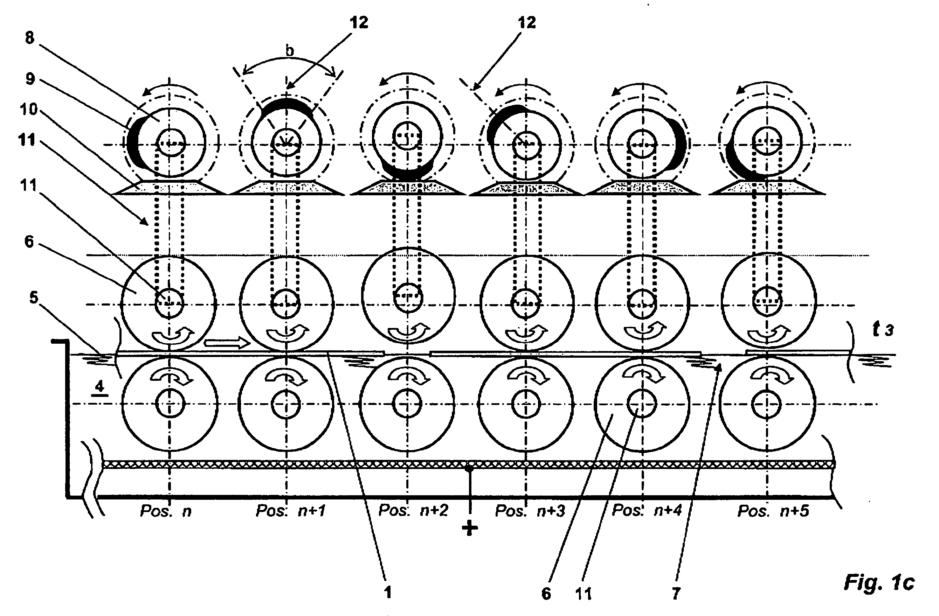

In **Figur 1 a** wird das Gut 1 durch den Arbeitsbehälter 2 der Durchlaufanlage von links nach rechts gefördert. Die Förderrichtung entlang der Transportbahn zeigt der Richtungspfeil 3. Die anderen Pfeile zeigen die Drehrichtungen der Bauteile. Die Behandlungsflüssigkeit 4 hat das Niveau 5 im Arbeitsbehälter 2. Es reicht bis an die Unterseite des Gutes 1 heran und benetzt diese Unterseite vollkommen, ohne dabei die Oberseite des Gutes zu benetzen. Hierzu werden die Höhenlange der unteren Fördermittel 6 an der Unterseite des Gutes 1 und das Niveau 5 sowie z.B. ein nicht dargestellter Überlauf des Arbeitsbehälters 2 aufeinander abgestimmt. Das untere Fördermittel 6 kann als Transportwalze, Transportwelle mit Rädchen, Scheiben, Ringen, Kontakträdern und dergleichen ausgeführt sein. Die Fördermittel werden z.B. von einer nicht dargestellten Transmissionswelle, die parallel und entlang der Transportbahn angeordnet ist, mittels Zahnräder als Kegelzahnräder und/oder Stirnzahnräder schlupffrei in der dargestellten Richtung rotierend angetrieben.

Die Fördermittel 6 an der Oberseite des Gutes 1 können ebenfalls als Walzen Rädchen, Scheiben, Ringe, Kontakträder und dergleichen auf Wellen 11 ausgeführt sein. Diese Fördermittel sollen, ebenso wie die Oberseite des Gutes 1, völlig trocken bleiben. Hierzu werden die Wellen angehoben, wenn sich zwischen zwei aufeinander folgenden Gütern eine Querlücke 7 einem Fördermittel 6 nähert. Ein Mittel zur Distanzierung der oberen Wellen vom Gut besteht aus mindestens einem Nockenrad 8 mit einer Nocke 9, die einen Zentriwinkel □ mit der Bogenlänge b aufweist. Bevorzugt befindet sich je ein Nockenrad 8 zu beiden Seiten der Transportbahn mit der selben Phasenlage $\varphi$ auf einer Welle 11, auf der sich auch die Fördermittel der entsprechenden Position in der Durchlaufanlage befinden. Ein weiteres steuerndes Nockenrad mit einer Nocke kann sich zur Stabilisierung der Welle auch im Bereich der axialen Mitte derselben befinden. Das Nockenrad kann z.B. mit dem nicht dargestellten Stirnzahnrad eine konstruktive Einheit bilden.

Die Welle 11 ist in den Figuren 1a bis 1c teilweise symbolisch gestrichelt dargestellt, weil je ein Nockenrad 8 in dieser Seitenansicht eigentlich hinter und vor dem oberen Fördermittel dargestellt werden müsste. Aus Gründen der besseren Darstellung ist in diesen Figuren nur ein Nockenrad 8 über den oberen Fördermitteln 6 angeordnet worden.

In der Position n + 4 befindet sich die Nocke 9 senkrecht auf der Nockenbahn 10. Die obere Welle 11 dieser Position befindet sich auf ihrer größten Höhenlage und damit auf der größten Distanz des Fördermittels von der Oberseite des Gutes 1. Diese Höhenlage bleibt bei der Rotation im Verlauf der Bogenlänge b erhalten. Die Bogenlänge b ist länger als die Querlücke 7 zwischen dem vor- und nachlaufenden Gut.

An derselben Position der Durchlaufanlage wiederholt sich periodisch das Distanzieren der Welle 11 nach dem Vorschub jeweils eines Gutes und einer Querlücke, d.h. nach der Bruttogutlänge $L_{gbr}$ mit der Periode T. Die Vorschubzeit ergibt sich aus dem Quotient von Bruttogutlänge $L_{gbr}$ zur Fördergeschwindigkeit v des Gutes. Die Vorschubzeit ist zugleich die Beschickungszeit tB der Durchlaufanlage, die auch als Taktzeit bezeichnet wird. Die Periode T steht mit der Beschickungszeit tB in einer festen Beziehung. Bevorzugt ist T = tB.

Bei besonders langem Gut in Förderrichtung erfolgt das Distanzieren ebenfalls periodisch, wobei jedoch erst bei z.B. jeder zweiten oder dritten Distanzierung eine Querlücke getroffen wird. Bei diesem langen Gut kann aus konstruktiven Gründen der Umfang u der Fördermittel nicht so groß realisiert werden, wie die Bruttogutlänge $L_{gbr}$ ist. Daher wird ein Stammbruchteil der Bruttogutlänge $L_{gbr}$ für den Umfang u der Fördermittel gewählt. Daraus folgt, dass auch die Periode T ein Stammbruchteil der Beschickungszeit tB der Durchlaufanlage ist. Für langes Gut gilt somit die Beziehung:

$$T = 1/x * tB,$$

wobei x eine ganze Zahl ist.

Die Fördergeschwindigkeit beträgt z.B. 1 m/Minute. Damit ergibt sich mit der oben gewählte Bruttogutlänge $L_{gbr}$ von 172,78 mm eine Periodenzeit von

$$T = 172,78 \ mm \ / \ 1000 \ mm/Minute$$

$$= 0,17278 \ Minute \ oder \ 10,34 \ Sekunden.$$

Diese Periodenzeit ist zugleich die Taktzeit der Durchlaufanlage. In dieser Zeit sind alle Förderspuren quer zur Transportrichtung einmal zu beschicken und in die Durchlaufanlage einzufahren.

Im Arbeitsbehälter 2 der Figur 1 ist eine Elektrode als Anode 13 dargestellt. Sie ist beim Galvanisieren der Unterseite des Gutes 1 mit dem Pluspol einer nicht dargestellten Badstromquelle verbunden. Der Minuspol ist mit den unteren oder oberen Fördermitteln als Kontaktmittel über elektrische Leiter und Dreh- oder Schleifkontakte mit diesen verbunden. Werden die oberen trockenen Fördermittel als Kontaktmittel verwendet, so entfällt sehr vorteilhaft das ansonsten notwendige Entmetallisieren der Kontaktmittel, da durch die Distanzierung von Gut und oberen Kontaktmitteln eine unerwünschte Metallisierung der Kontakte vermieden wird. Dafür muss jedoch von der Oberseite des Gutes zur zu galvanisierenden Unterseite eine elektrische Verbindung bestehen, was oft gegeben ist.

In der Position n + 1 befindet sich das Fördermittel gerade wieder in der Abwärtsbewegung, nachdem die Querlücke 7 vorüber gefahren ist. Die Figur 1a zeigt die Situation zum Zeitpunkt t1. Die **Figur 1b** zeigt diese Situation nach einer

Phasendrehung $\varphi$ der Welle 11 von ca. 45°, d.h. nach einer achtel Umdrehung. In dieser Zeit ist das Gut um eine Strecke vorwärts transportiert worden, die 1/8 der Bruttogutlänge $L_{gbr}$ entspricht. Zum Zeitpunkt t2 sind die Fördermittel bis auf die Position n + 2, in der die Distanzierung beginnt, im Eingriff. Die **Figur 1c** zeigt die Situation nach einer weiteren achtel Umdrehung zum Zeitpunkt t3. Im Bereich der Position n + 2 befindet sich gerade eine Querlücke und in Position n + 5 beginnt das Entfernen der Fördermittel vom Gut.

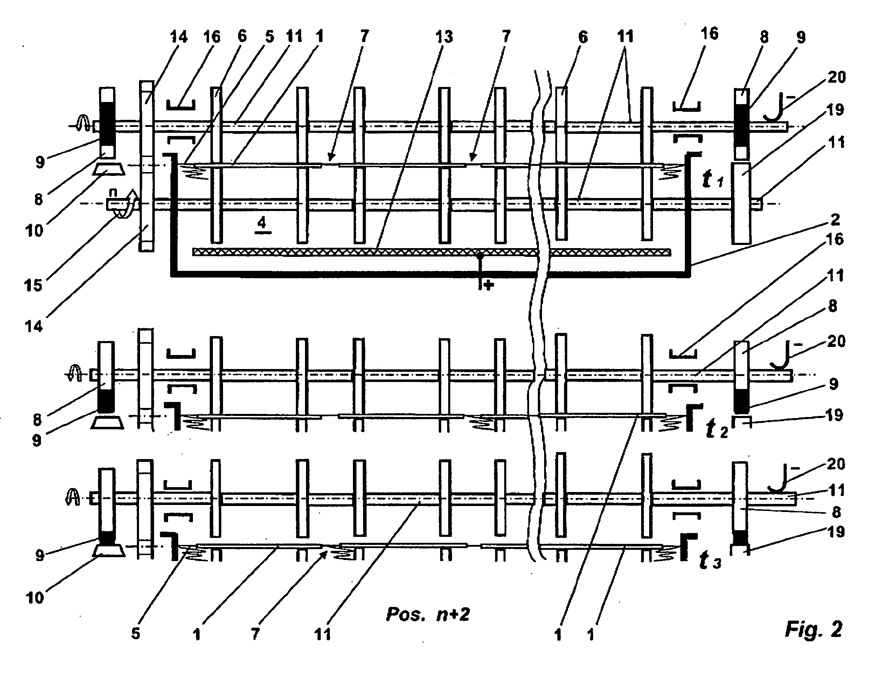

Die **Figur 2** zeigt dieselbe Durchlaufanlage in der Ansicht quer zur Förderrichtung bei der Position n + 2 zu den drei Zeitpunkten der Figuren 1a bis 1c. Diese Ansicht ist in der Querlänge verkürzt dargestellt. Im oberen Teil der Figur 2 sind obere und untere Wellen 11 und Fördermittel 6 in dem Arbeitsbehälter 2 dargestellt. Im unteren Teil für die Zeiten t2 und t3 sind jeweils nur die oberen Fördermittel vollständig dargestellt.

Die untere Welle 11 mit ihren Fördermitteln 6 ist am Arbeitsbehälter 2 gelagert und in ihrer Höhenlage so eingestellt, dass das Niveau 5 der Behandlungsflüssigkeit gerade an die Unterseite des Gutes 1 heranreicht. Diese Welle wird z.B. von der nicht dargestellten parallel zur Durchlaufanlage verlaufenden Transmissionswelle und einem Zahnrad ebenso in Rotation versetzt, wie alle anderen Wellen der Durchlaufanlage. Der Antriebspfeil 15 deutet dies an. Bevorzugt gleich große Stirnzahnräder 14 übertragen die Rotation auf die obere Welle 11. Die Lager 16 der oberen Welle 11 sind so ausgebildet, dass die Welle mit seitlicher Führung nach oben ausweichen kann. Dieses Ausweichen geschieht dann, wenn die Nocke 9 auf die Nockenbahn 10 aufläuft. Dies ist zum Zeitpunkt t3 der Fall. Hier ist die gesamte Welle quer zur Förderrichtung vom Gut abgehoben worden, weil sich in ihrem Bereich gerade eine Querlücke der Güter befindet. Hierzu wurden die Phasenlage $\varphi$ der Nocke 9 des Nockenrades 8 sowie die antreibenden Zahnräder der Transmissionswelle und der Stirnzahnräder 14 formschlüssig synchronisiert, d.h. in einen festen Bezug zueinander gebracht und eingestellt. Diese Einstellungen bestimmen den Startzeitpunkt aller Güter an der Beschickung der Durchlaufanlage unter Berücksichtigung ihrer Bruttogutlänge $L_{gbr}$ derart, dass sich dieses Ausweichen der Welle und damit das Distanzieren der Fördermittel von der Gutoberfläche periodisch stets bei derselben Situation wie sie zum Zeitpunkt t3 dargestellt ist, wiederholt.

Die Figur 2 zeigt rechts ein weiteres mögliches Ausführungsbeispiel der Nockensteuerung. An Stelle der links dargestellten linearen Nockenbahn 10 ist rechts eine kreisförmige Nockenbahn als Distanzrad 19 angeordnet. Dieses Distanzrad 19 ist auf der unteren Welle 11 gelagert. Damit entfällt der für eine lineare Nockenbahn erforderliche gesonderte Befestigungspunkt am Arbeitsbehälter 2. Besonders vorteilhaft ist dieses Distanzrad 19 dann, wenn es auch in der axialen Mitte der Welle erforderlich ist. Das Nockenrad 8 läuft mit seiner Nocke 9 erst auf dem Distanzrad 19 auf, wenn die obere Welle kurzzeitig ausgehoben werden soll. Das Nockenrad 8 kann sich auch auf der unteren Welle 11 befinden. Entsprechend ist dann des Distanzrad 19 auf der oberen Welle angeordnet, jeweils wieder mindestens an beiden Seiten der Welle 11. Die elektrischen Dreh- oder Schleifkontakte 20 dienen bei einer elektrolytischen Behandlung zur Stromübertragung auf die rotierenden Wellen und von dort zu den Kontakträdern.

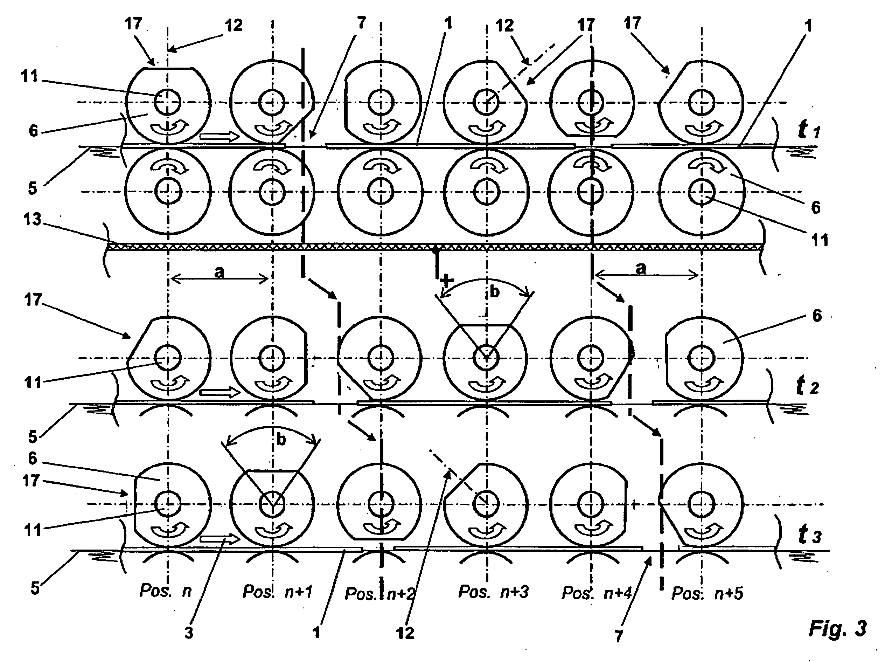

Die **Figur 3** zeigt für das zweite Mittel zur Ausführung der Erfindung ein Beispiel in der Seitenansicht mit Wellen 11 in den Positionen n bis n + 5 entlang der Transportbahn der Durchlaufanlage zu den Zeitpunkten t1, t2 und t3. Bei dem Phasenwinkel 12 mit $\varphi$ = 0° befindet sich eine Aussparung 17 des kreisförmigen oberen Fördermittels 6. Diese Aussparung ist hier als Segment mit der Bögenlänge b dargestellt. Allgemein hat die Aussparung 17 eine beliebige Form, wobei entlang der Bogenlänge b ein Radius besteht, der kleiner ist als der Radius des übrigen Fördermittels. Die Form der Aussparung 17 am Fördermittel beschränkt sich somit nicht auf das dargestellte Segment. So wird z.B. der Übergang zum kleineren Radius bevorzugt abgerundet ausgeführt.

Die Bogenlänge b wird wieder größer gewählt, als die Länge der Querlücke und zwar um den Sicherheitszuschlag z. Zum Zeitpunkt t1 sind in der Position n + 4 alle Fördermittel einer Welle 11 vom Gut 1 entfernt. Im darunter dargestellten Zeitpunkt t2 sind alle Fördermittel aller oberen Wellen in Kontakt mit der Oberseite des Gutes 1. Der Vorschub des Gutes 1 betrug wieder eine Strecke, die der erfolgten Drehung der Fördermittel um einen Phasenwinkel von ca. 45° entspricht. Nach einer weiteren Drehung von 45° haben sich zum Zeitpunkt t3 die oberen Fördermittel der Welle 11 in Position n + 2 vom Gut 1 entfernt. Die Lager 16 der oberen Wellen 11 sind in ihrer Höhenlage so hoch positioniert, dass diese Wellen 11 z.B. in Position n + 2 zum Zeitpunkt t3 von den Lagern 16 getragen werden, um die Distanzierung der oberen Fördermittel 6 vom Gut 1 aufrecht zu erhalten. Andernfalls würden die mit Aussparungen 17 versehenen Fördermittel 6 auch im Bereich der Aussparung 17 das Gut berühren. Des Weiteren sind die Lager 16 in der anderen Begrenzung so tief eingestellt, dass die Fördermittel im übrigen Umfangsbereich sicher auch auf einem sehr dünnen Gut aufliegen und dieses gegebenenfalls elektrisch kontaktieren können. Der Mittenabstand der oberen und unteren Wellen bleibt somit nahezu konstant, auch wenn sich eine Aussparung über dem Gut befindet.

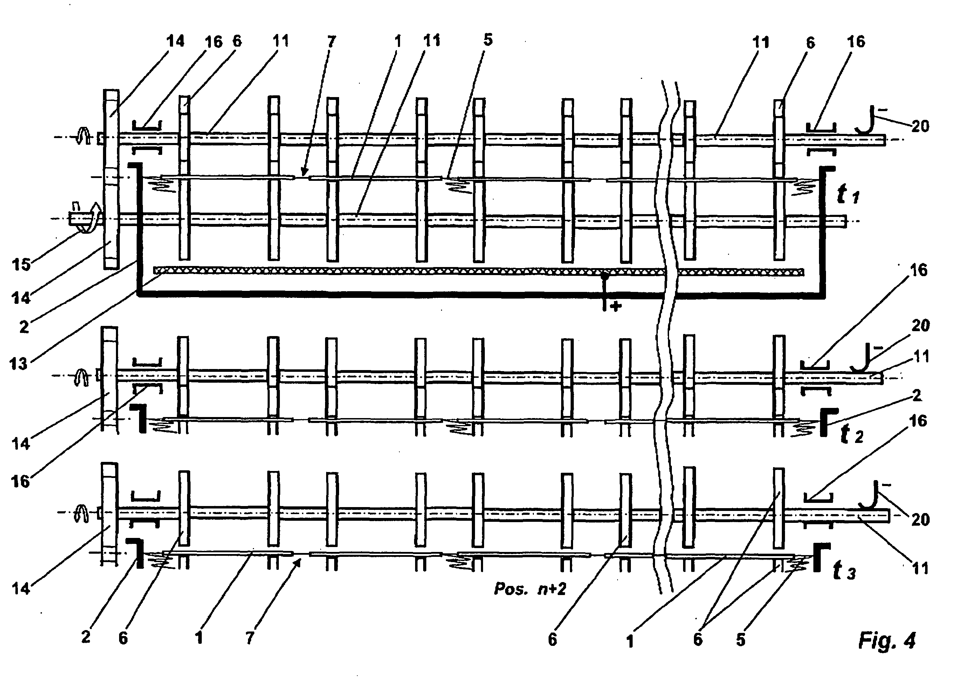

Diese Situationen gemäß der Figur 3 zeigt die **Figur 4** mit Blick quer zur Förderrichtung. Zum Zeitpunkt t3 tragen die Lager 16 die Welle 11 zu den anderen Zeitpunkten liegen die Fördermittel 6 auf dem Gut auf. Die oberen Lager 16 übernehmen dabei nur die seitliche Führung der Wellen. Die Aufrechterhaltung der Distanzierung zum Zeitpunkt t3 in der Figur 4 kann an Stelle der Lager auch durch nicht dargestellte Abstandsräder auf den Wellen realisiert werden.

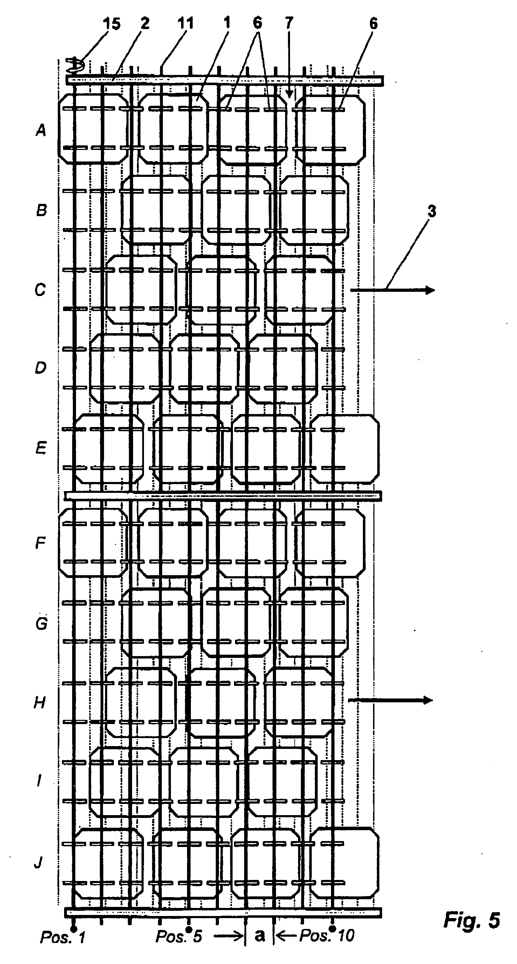

Die **Figur 5** zeigt die Situation an der Beschickung der Durchlaufanlage in der Draufsicht. Sie gilt für die Ausführung der Erfindung gemäß der Figuren 3 und 4. Bei dieser Ausführung lassen sich für jede Förderspur A bis J die Fördermittel 6 in ihrer Phasenlage $\varphi$ und damit auch ihre Startzeit individuell einstellen. Bei gleichbleibender Bruttogutlänge $L_{gbr}$ bleibt diese Einstellung unverändert bestehen. Die Beschickung des Gutes, hier als Solarzellen, erfolgt z.B. mittels zweier Handhabungsgeräte, die die Durchlaufanlage sequentiell beschicken. Durch die Zweiteilung steht für jedes Gut die doppelte Taktzeit bzw. Beschickungszeit tB zur präzisen Handhabung zur Verfügung. Im obigen Beispiel

sind es

$$tB = 10,34 \text{ Sekunden / 5 Förderspuren}$$

$$= 2,07 \text{ Sekunden / Förderspur.}$$

Gleiches gilt für die Entleerung nach der Durchlaufanlage. Die Ausführung der Erfindung gemäß den Figuren 1a bis 1c und 2 erfordert ein gleichzeitiges Beschicken aller Förderspuren A bis J. Das Gut wird dann parallel in Reihen durch die Durchlaufanlage gefördert. Für diese parallele Beschickung und Förderung eignet sich natürlich auch die Erfindung gemäß der Figuren 3 und 4. Es besteht auch die Möglichkeit, zwei oder drei Güter gemeinsam, d.h. zum selben Zeitpunkt zu beschicken. Entsprechend gleich sind die Phasenwinkel der Fördermittel auf den Wellen für die jeweiligen Förderspuren einzustellen.

Liste der Bezugzeichen und Abkürzungen

| 1 | Gut, Güter |
|---|---|
| 2 | Arbeitsbehälter |
| 3 | Richtungspfeil |
| 4 | Behandlungsflüssigkeit |
| 5 | Niveau |
| 6 | Fördermittel |
| 7 | Querlücke |
| 8 | Nockenrad |
| 9 | Nocke |
| 10 | Nockenbahn |
| 11 | Welle, Transportwelle |
| 12 | Phasenwinkel $\varphi = 0°$ |
| 13 | Anode, Elektrode |
| 14 | Stirnzahnrad |
| 15 | Antriebspfeil |
| 16 | Lager |
| 17 | Aussparung |
| 18 | Sehne |
| 19 | Distanzrad |
| 20 | Drehkontakt, Schleifkontakt |
| $L_g$ | Gutlänge |
| $L_{gbr}$ | Bruttogutlänge |
| $L_{qlü}$ | Querlückenlänge |
| $L_{11ü}$ | Längslückenbreite |
| u | Umfang des Fördermittels |
| b | Bogenlänge |
| $\varphi$ | Phasenwinkel |
| $\beta$ | Zentriwinkel |
| v | Fördergeschwindigkeit |
| T | Periode |
| a | Abstand der Wellen in Förderrichtung |
| tB | Beschickungszeit, Taktzeit der Durchlaufanlage |

**Patentansprüche**

1. Vorrichtung zum Fördern von flachem Gut (1) in horizontaler Ausrichtung in Durchlaufanlagen zur einseitigen nasschemischen und/oder elektrolytischen Behandlung mittels rotierender Wellen (11) oder Walzen mit darauf befindlichen Fördermitteln (6) als Transportmittel und/oder Kontaktmittel, wobei die innerhalb eines Arbeitsbehälters (2) befindliche Behandlungsflüssigkeit (4) nur bis an die zu behandelnde Unterseite des Gutes heranreicht, **gekennzeichnet durch** mindestens ein Mittel zur periodischen Distanzierung mindestens der auf der Oberseite des Gutes (1) abrollenden Fördermittel (6) von dieser Oberseite, wobei die Periode T gleich groß ist wie die Beschickungszeit tB oder wie ein Stammbruchteil der Beschickungszeit tB des Gutes.

2. Vorrichtung nach Patentanspruch 1, **dadurch gekennzeichnet, dass** der äußere Umfang u der mindestens oberen rotierenden Fördermittel (6) der Summe der Länge $L_g$ des Gutes plus der Querlückenlänge $L_{qlü}$ von Gut zu Gut in Förderrichtung entspricht oder ein ganzzahliges Vielfaches oder ein Stammbruchteil dieser Summe beträgt.

3. Vorrichtung nach Patentanspruch 1 oder 2, **gekennzeichnet durch** formschlüssige und/oder kraftschlüssige Mittel zur Steuerung der periodischen Distanzierung der Fördermittel von der oder den Oberfläche(n) des Gutes, wobei diese Steuerung mit dem Antrieb der Durchlaufanlage und der darin befindlichen Fördermittel untereinander synchronisiert ist.

4. Vorrichtung nach einem der Patentansprüche 1 bis 3, **dadurch gekennzeichnet, dass** die Fördermittel (6) an dem Umfang, der auf dem Gut abrollt, mindestens eine Aussparung (17) aufweisen mit der Bogenlänge b als Abstandsbogen, dessen Radius kleiner ist als der Radius des übrigen rotierenden Fördermittels außerhalb der Bogenlänge b, wodurch der Abstandsbogen bei Rotation des Fördermittels die Oberfläche des Gutes im Bereich des Bogens b nicht berührt.

5. Vorrichtung nach einem der Patentansprüche 1 bis 4, **gekennzeichnet durch** ein Fördermittel, das am Umfang die Form eines Segmentes als Aussparung (17) hat, wobei diese mindestens eine Aussparung (17) bei Rotation des Fördermittels die Oberfläche des Gutes nicht berührt.

6. Vorrichtung nach einem der Patentansprüche 1 bis 5, **gekennzeichnet durch** eine Höhenlage der Lager (16) der Wellen (11) und/oder Abstandsräder auf der Welle, die so dimensioniert sind, dass die Oberfläche des Gutes von den Fördermitteln nur dann nicht berührt und kontaktiert werden kann, wenn sich der Abstandsbogen mit der Bogenlänge b in der Nähe des Niveaus (5) der Behandlungsflüssigkeit (4) befindet.

7. Vorrichtung nach einem der Patentansprüche 1 bis 6, **gekennzeichnet durch** eine sequentielle Beschickung der Durchlaufanlage mit Gut, wobei der Startzeitpunkt in jeder Förderspur und die Phasenlage $\varphi = 0°$ aller Fördermittel dieser Förderspur aufeinander derart zeitlich abgestimmt sind, dass die oberen Fördermittel im Bereich einer Querlücke (7) das Gut und die zugehörigen unteren Fördermittel nicht berühren.

8. Vorrichtung nach einem der Patentansprüche 1 bis 7, **gekennzeichnet durch** eine gleich ausgerichtete Phasenlage $\varphi$ der Fördermittel (6) auf einer Mantellinie jeder Welle (11) zur gleichzeitigen Beschickung der Durchlaufanlage mit mehreren parallelen Gütern quer zur Förderrichtung.

9. Vorrichtung nach einem der Patentansprüche 1 bis 8, **gekennzeichnet durch** versetzt ausgerichtete Phasenlagen $\varphi$ der Fördermittel (6) auf versetzten Mantellinien jeder Welle (11) zur sequentiellen Beschickung der Durchlaufanlage mit Gütern quer zur Förderrichtung.

10. Vorrichtung nach einem der Patentansprüche 1 bis 9, **gekennzeichnet durch** Fördermittel mit Aussparungen (17) als Kreisbogen oder Segment mit einem kleineren Radius als der des übrigen Fördermittels.

11. Vorrichtung nach einem der Patentansprüche 1 bis 10, **gekennzeichnet durch** Mittel zur Distanzierung von Gut und Fördermitteln als mindestens zwei Nockenräder (8) mit mindestens jeweils einer Nocke (9) auf mindestens einer oberen oder unteren Welle (11) und zugehörige feststehende Nockenbahnen (10) oder rotierende Distanzräder (19).

12. Verfahren zum Fördern von flachem Gut in horizontaler Ausrichtung in Durchlaufanlagen zur einseitigen nasschemischen und/oder elektrolytischen Behandlung mittels rotierender wellen oder Walzen mit darauf befindlichen Fördermitteln als Transportmittel und/oder Kontaktmittel, wobei die innerhalb eines Arbeitsbehälters (2) befindliche Behandlungsflüssigkeit nur bis an die zu behandelnde Unterseite des Gutes heranreicht unter Verwendung der Vorrichtung nach einem der Patentansprüche 1 bis 11 **dadurch gekennzeichnet, dass** durch periodisches Entfernen der oberen Fördermittel von der Oberfläche des Gutes mindestens für die Zeit, in der sich eine Querlücke von zwei aufeinander folgenden Gütern im Bereich der Fördermittel befindet, diese oberen Fördermittel von der Behandlungsflüssigkeit nicht benetzt werden.

**13.** Verfahren nach Patentanspruch 12, **dadurch gekennzeichnet, dass** sich durch Steuerelemente die Fördermittel (6) einer Welle (11) gemeinsam von der Oberfläche des Gutes entfernen und ihr wieder annähern.

**14.** Verfahren nach Patentanspruch 12 oder 13, **dadurch gekennzeichnet, dass** sich mittels Aussparungen an den Fördermitteln (6) einer Welle (11) diese Fördermittel (6) gemeinsam, in Gruppen oder zu unterschiedlichen Zeitpunkten von der Oberfläche des Gutes entfernen und ihr wieder annähern.

**15.** Verfahren nach einem der Patentansprüche 12 bis 14, **dadurch gekennzeichnet, dass** die Distanzierung von Gut und Fördermittel durch formschlüssiges und/oder kraftschlüssiges und mit dem Antrieb der Fördermittel der Durchlaufanlage synchronisiertes Steuern erfolgt.

**16.** Verfahren nach einem der Patentansprüche 12 bis 15, **dadurch gekennzeichnet, dass** die erforderlichen Bewegungen zur periodischen Entfernung von Gut und Fördermitteln vom Antrieb der Fördermittel abgeleitet und synchronisiert werden.

**17.** Verfahren nach einem der Patentansprüche 12 bis 16, **dadurch gekennzeichnet, dass** bei elektrolytischen Prozessen das Unterbrechen der Stromzuführung zu bestimmten Zeiten mit der Förderung des Gutes synchronisiert wird.

**Claims**

**1.** Apparatus for the conveying of flat good (1) in horizontal orientation in inline plants for the single-sided wet chemical and/or electrolytic treatment by means of rotating shafts (11) or rolls with conveying means (6) arranged thereon as transport means and/or contact means, wherein the treatment liquid (4) which is present within a working tank (2) does only reach up to the good's underside to be treated, **characterized by** at least one means for the periodic spacing-away from this upper side of at least the conveying means (6) which roll along the upper side of the good (1), wherein the cycle T is equal to the feed time tB, or to a unit fraction of the feed time tB of the good.

**2.** Apparatus according to claim 1, **characterized in that** the outer circumference u of the at least upper rotating conveying means (6) corresponds to the sum of the length $L_g$ of the good plus the transverse gap length $L_{qlu}$ from good to good in conveying direction, or is an integer multiple or a unit fraction of this sum.

**3.** Apparatus according to claim 1 or 2, **characterized by** form-locking and/or force-locking means for control of the periodic distancing of the conveying means from the surface(s) of the good, wherein this control is synchronized with the drive of the inline plant and the conveying means contained therein.

**4.** Apparatus according to any of claims 1 to 3, **characterized in that** the conveying means (6), at the circumference which rolls along the good, have at least one recess (17) with the are length b as distance are whose radius is smaller than the radius of the remaining rotating conveying means outside of the arc length b, whereby the distance arc, upon rotation of the conveying means, does not touch the surface of the good in the region of the arc b.

**5.** Apparatus according to any of claims 1 to 4, **characterized by** a conveying means which has, at its circumference, the shape of a segment as a recess (17), wherein this at least one recess (17), upon rotation of the conveying means, does not touch the surface of the good.

**6.** Apparatus according to any of claims 1 to 5, **characterized by** a height level of the shaft's (11) bearings (16) and/or of the spacer wheels on the shaft which are dimensioned such that the surface of the good cannot be touched and contacted by the conveying means only if the distance arc with the arc length b is located in proximity to the level (5) of the treatment liquid (4).

**7.** Apparatus according to any of claims 1 to 6, **characterized by** a sequential supply of the inline plant with good, wherein the starting time in each conveying track and the phase position φ = 0° of all conveying means of this conveying track are time-coordinated to one another in such a manner that the upper conveying means do not touch the good and the corresponding lower conveying means in the region of a transverse gap (7).

**8.** Apparatus according to any of claims 1 to 7, **characterized by** an equally adjusted phase position φ of the conveying means (6) on a surface line of each shaft (11) for the simultaneous supply of the inline plant with several parallel goods perpendicular to the conveying direction.

9. Apparatus according to any of claims 1 to 8, **characterized by** offset oriented phase positions φ of the conveying means (6) on offset surface lines of each shaft (11) for the sequential supply of the inline plant with goods perpendicular to the conveying direction.

10. Apparatus according to any of claims 1 to 9, **characterized by** conveying means with recesses (17) as circular arc or segment with a radius smaller than the one of the remaining conveying means.

11. Apparatus according to any of claims 1 to 10, **characterized by** means for the distancing of good and conveying means as at least two cam wheels (8) with at least one cam (9) on at least one upper or lower shaft (11) and related fixed cam tracks (10) or rotating spacer wheels (19).

12. Method for the conveying of flat good in horizontal orientation in inline plants for the single-sided wet chemical and/or electrolytic treatment by means of rotating shafts or rolls with conveying means arranged thereon as transport means and/or contact means, wherein the treatment liquid which is present within a working tank (2) does only reach up to the good's underside to be treated, by using the apparatus as defined in any of claims 1 to 11, **characterized in that** due to periodic distancing of the upper conveying means from the surface of the good for at least the time in which a transversal gap of two subsequent goods is present in the region of the conveying means, these upper conveying means are not wetted by the treatment liquid.

13. Method according to claim 12, **characterized in that** the conveying means (6) of a shaft (11), by means of control elements, collectively depart from the surface of the good and re-approach the same.

14. Method according to claim 12 or 13, **characterized in that** the conveying means (6), by means of recesses at these conveying means (6) of a shaft (11), do collectively, in groups, or at different time points depart from the surface of the good and re-approach the same.

15. Method according to any of claims 12 to 14, **characterized in that** the distancing of good and conveying means is effected by form-locking and/or force-locking control being synchronized with the drive of the conveying means of the inline plant.

16. Method according to any of claims 12 to 15, **characterized in that** the necessary movements for the periodic distancing of good and conveying means are deduced from the drive of the conveying means and synchronized.

17. Method according to any of claims 12 to 16, **characterized in that** the interrupting of the current supply at specific times during electrolytic processes is synchronized with the conveyance of the good.

**Revendications**

1. Dispositif pour le transport d'article plat (1) sur le plan horizontal dans une installation en chaîne automatique pour le traitement chimique par voie aqueuse et/ou électrolytique d'un seul coté au moyen d'arbres (11) ou cylindres rotatifs sur lesquels se trouve des agents de convoyage (6) comme moyen de transport et/ou moyen de contact, dans lequel le liquide de traitement (4) qui se trouve dans une cuve de traitement (2), atteint seulement le niveau de la face inférieure à traiter de l'article, **caractérisé par** au moins un agent servant à mettre à distance périodique au moins les agents de convoyage (6) se trouvant du coté supérieur de l'article (1) de ce coté supérieur, la période T étant égale au temps total de chargement tB ou une fraction unitaire du temps total de chargement tB de l'article.

2. Dispositif selon la revendication 1, **caractérisé en ce que** la circonférence externe u des, au moins les supérieurs, agents de convoyage (6) rotatifs correspond à la somme de la longueur $L_g$ de l'article plus la longueur de l'intervalle transversal $L_{qlu}$ d'un article au suivant dans la direction du transport ou est un multiple entier ou une fraction unitaire de cette somme.

3. Dispositif selon la revendication 1 ou la revendication 2, **caractérisé par** des outils de liaison de forme et/ou de force pour le contrôle de la mise à distance périodique des agents de convoyage de la ou les surface(s) de l'article, ce contrôle étant synchronisé avec l'entrainement de la chaîne automatique et les agents de convoyage qui s'y trouvent.

**4.** Dispositif selon une des revendications 1 à 3, **caractérisé en ce que** les agents de convoyage (6) présentent sur la circonférence qui roule sur l'article, au moins une découpe (17) avec une longueur d'arc b comme arc de distanciation dont le rayon est plus petit que le rayon du reste de l'agent de convoyage rotatif au-delà de la longueur d'arc b, moyennant quoi l'arc de distanciation, lors de la rotation de l'agent de convoyage, ne touche pas la surface de l'article au niveau de l'arc b.

**5.** Dispositif selon une des revendications 1 à 4, **caractérisé par** un agent de convoyage qui porte sur la circonférence une découpe (17) en forme de segment, cette, au moins une, découpe (17), lors de la rotation de l'agent de convoyage, ne touchant pas la surface supérieure de l'article.

**6.** Dispositif selon une des revendications 1 à 5, **caractérisé par** une cote de niveau de la portée de roulement (16) des arbres (11) et/ou des roues de mise à distance sur l'arbre qui sont dimensionnées de telle manière que la surface de l'article ne peut pas être touchée et en contact avec les agents de convoyage seulement lorsque l'arc de distanciation avec la longueur d'arc b se trouve à proximité du niveau (5) du liquide de traitement (4).

**7.** Dispositif selon une des revendications 1 à 6, **caractérisé par** une alimentation séquentielle de la chaîne automatique avec l'article, le moment du démarrage sur chaque piste de transport et la position de phase $\varphi = 0°$ de tous les agents de convoyage sur cette piste de transport étant coordonnés entre eux de telle manière que les agents de convoyage supérieurs ne touchent pas l'article et les agents de convoyage inférieurs correspondants au niveau d'un intervalle transversal (7).

**8.** Dispositif selon une des revendications 1 à 7, **caractérisé par** une position de phase $\varphi$ ajustée de manière identique pour les agents de convoyage (6) sur une ligne génératrice de chaque arbre (11) pour l'alimentation simultanée de la chaîne automatique avec plusieurs articles en parallèle perpendiculairement à la direction du transport.

**9.** Dispositif selon une des revendications 1 à 8, **caractérisé par** des positions de phase $\varphi$ ajustées de manière décalée pour les agents de convoyage (6) sur des lignes génératrices décalées de chaque arbre (11) pour l'alimentation séquentielle de la chaîne automatique avec des articles perpendiculairement à la direction du transport.

**10.** Dispositif selon une des revendications 1 à 9, **caractérisé par** des agents de convoyage avec des découpes (17) comme un arc de cercle ou un segment avec un rayon plus petit que celui du reste de l'agent de convoyage.

**11.** Dispositif selon une des revendications 1 à 10, **caractérisé par** des agents de mise à distance de l'article et des agents de convoyage comme au moins deux roues à came (8) avec au moins une came (9) chacune sur au moins un arbre (11) inférieur ou supérieur et des pistes de came fixes (10) ou des roues de mise à distance (19) rotatives correspondantes.

**12.** Procédé pour le transport d'article plat (1) sur le plan horizontal dans une installation en chaîne automatique pour le traitement chimique par voie aqueuse et/ou électrolytique d'un seul coté au moyen d'arbres ou cylindres rotatifs sur lesquels se trouve des agents de convoyage comme moyen de transport et/ou moyen de contact, dans lequel le liquide de traitement qui se trouve dans une cuve de traitement (2), atteint seulement le niveau de la face inférieure à traiter de l'article, en utilisant le dispositif selon une des revendications 1 à 11, **caractérisé en ce que** grâce à la mise à distance périodique des agents de convoyage supérieurs de la surface de l'article, au moins pour le temps dans lequel un intervalle transversal entre deux articles successifs se trouve au niveau des agents de convoyage, ces agents de convoyage supérieurs ne sont pas mouillés par le liquide de traitement.

**13.** Procédé selon la revendication 12, **caractérisé en ce que** grâce à des éléments de contrôle, les agents de convoyage (6) d'un arbre (11) ensembles s'éloignent de la surface de l'article et s'en rapprochent de nouveau.

**14.** Procédé selon la revendication 12 ou la revendication 13, **caractérisé en ce que** au moyen de découpes sur les agents de convoyage (6) d'un arbre (11), ces agents de convoyage (6) ensembles, par groupe ou à des moments différents s'éloignent de la surface de l'article et s'en rapprochent de nouveau.

**15.** Procédé selon une des revendications 12 à 14, **caractérisé en ce que** la mise à distance de l'article et des agents de convoyage se produit par une commande de liaison de forme et/ou de force synchronisée avec la propulsion des agents de convoyage de la chaîne automatique.

**16.** Procédé selon une des revendications 12 à 15, **caractérisé en ce que** les mouvements nécessaires à l'éloignement périodique de l'article et des agents de convoyage sont dérivés de la propulsion des agents de convoyage et sont synchronisés avec celle-ci.

17. Procédé selon une des revendications 12 à 16, **caractérisé en ce que** lors de processus électrolytiques, l'interruption de l'alimentation en courant à des temps donnés est synchronisée avec le transport de l'article.

Fig. 1a

EP 2 060 659 B1

Fig. 1b

Pos. n  Pos. n+1  Pos. n+2  Pos. n+3  Pos. n+4  Pos. n+5

$t_2$

+

b

8
9
10
11
11
6
5
12
12
7
11
6
1
13
7
4

Fig. 1c

Pos. n+2

Fig. 2

EP 2 060 659 B1

Fig. 3

EP 2 060 659 B1

Fig. 4

EP 2 060 659 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005038449 A1
- EP 0992617 A2
- DE 2256018 C3
- DE 102005039100 A1
- DE 10313127 B4
- DE 102005062528 A1